# EUROPEAN PATENT APPLICATION

(11) **EP 4 738 006 A2**
(43) Date of publication of application: **06.05.2026**
(21) Application number: 25212230.4
(22) Date of filing: 30.10.2025
(51) Int. Cl.: G03F 1/24, G03F 1/48

(54) **REFLECTIVE MASK BLANK AND METHOD FOR MANUFACTURING REFLECTIVE MASK**

(30) Priority: 30.10.2024 JP 2024190213
(71) Applicant: SHIN-ETSU CHEMICAL CO., LTD., Tokyo 1000005 (JP)
(72) Inventor: INAZUKI, Yukio, Niigata, 942-8601 (JP); KOSAKA, Takuro, Niigata, 942-8601 (JP); OGOSE, Taiga, Niigata, 942-8601 (JP); SAKURAI, Keisuke, Niigata, 942-8601 (JP); MIMURA, Shohei, Niigata, 942-8601 (JP); KANEKO, Hideo, Niigata, 942-8601 (JP)
(74) Representative: Hindles Limited

(57) **Abstract**

A reflective mask blank comprises: a substrate (1); a multilayer reflective film (2) that reflects the exposure light and is formed above one main surface of the substrate (1); a protective film (3) that protects the multilayer reflective film (2) and is formed above the multilayer reflective film (2); an absorption film (6) that absorbs the exposure light and is formed above the protective film (3); and an intermediate film provided between the protective film (3) and the absorption film (6). The intermediate film includes a first intermediate film (4) containing niobium (Nb) and a second intermediate film (5) that is provided closer to the absorption film (6) than the first intermediate film (4) and is made of a material that can be dry-etched with an oxygen-containing gas. The absorption film (6) is made of a material that can be dry-etched with a fluorine-containing gas.

## Description

### Technical Field

The present invention relates to a reflective mask blank that is a material for a reflective mask used for manufacturing a semiconductor device such as an LSI, and a method for manufacturing a reflective mask from the reflective mask blank.

### Background Art

In the manufacturing process of semiconductor devices, a photolithography technique for irradiating a transfer mask with exposure light and transferring a circuit pattern formed on the mask onto a semiconductor substrate (semiconductor wafer) via a reduction projection optical system is repeatedly used. In the related art, the wavelength of exposure light is mainly 193 nm, which is argon fluoride (ArF) excimer laser light, and a pattern having smaller dimensions than the exposure wavelength has been finally formed by adopting a process called multi-patterning in which an exposure process and a processing process are combined a plurality of times.

However, it has been necessary to form even finer patterns due to continuous miniaturization of device patterns, and thus an EUV lithography technique using extreme ultraviolet (hereinafter, referred to as "EUV") light having a wavelength shorter than that of ArF excimer laser light as exposure light has been used. EUV light is light having a wavelength of about 0.2 to 100 nm, more specifically, light having a wavelength of around 13.5 nm. Since EUV light has extremely low transparency to substances, transmission type projection optical systems and masks of the related art cannot be used, and thus reflection type optical elements are used. Therefore, a reflective mask is also used as a mask for pattern transfer.

In the reflective mask, a multilayer reflective film that reflects EUV light is formed on a substrate, and a pattern of an absorption film that absorbs EUV light is formed on the multilayer reflective film. Meanwhile, the material before patterning of the absorption film (including the material with a resist film formed thereon) is called a reflective mask blank, and the reflective mask blank is used as a material for the reflective mask. In general, the reflective mask blank has a basic structure including a low thermal expansion substrate, a multilayer reflective film that reflects EUV light and is formed on one of two main surfaces of the substrate, and an absorption film that absorbs EUV light and is formed on the multilayer reflective film.

As the multilayer reflective film, a multilayer reflective film that obtains a necessary reflectivity for EUV light by alternately laminating a molybdenum (Mo) layer and a silicon (Si) layer is usually used. As the absorption film, tantalum (Ta) or the like having a relatively large extinction coefficient for EUV light is used (JP 2002-246299 A).

Furthermore, as a protective film (capping film) for protecting the multilayer reflective film during washing of the reflective mask or the like, a ruthenium (Ru) film or a rhodium (Rh) film as disclosed in JP 2002-122981 A or JP 2005-516182 T is formed on the multilayer reflective film. In addition, as an etching mask for when a pattern is formed on the absorption film, a hard mask film containing chromium (Cr) may be formed on the absorption film. Meanwhile, a conductive film is formed on the other main surface of the substrate. As the conductive film, a metal nitride film is proposed for electrostatic chucking, and examples thereof include films mainly containing chromium (Cr) and tantalum (Ta).

### SUMMARY OF INVENTION

### PROBLEM TO BE SOLVED BY INVENTION

In a mask for EUV exposure, a Ta-based absorption film of about 70 nm or 60 nm is used as a light shielding film in the related art. However, the absorption film is required to be thin to reduce the mask 3D effect during EUV exposure, and various materials are proposed. However, even in a case where a film exhibiting optically better characteristics than the Ta-based absorption film of the related art was used, problems arose such as damage to the protective film during mask processing due to a low etching rate during mask processing.

The present invention has been made to solve the problems, and an object thereof is to provide a reflective mask blank in which a protective film is not damaged during mask processing, and a method for manufacturing a reflective mask using the reflective mask blank.

The inventors of the present application have conducted intensive studies to solve the problems, and as a result, found that, when an absorption film that can be etched with a fluorine-containing gas is used, the problems can be solved by providing, between a protective film and the absorption film, at least two layers of intermediate films having a layer containing niobium (Nb) on the protective film side and a layer made of a material that can be etched with an oxygen-containing gas on the absorption film side, and completed the present invention.

### MEANS FOR SOLVING PROBLEM

Therefore, the present invention provides the following reflective mask blank and method for manufacturing a reflective mask.

A reflective mask blank according to the present invention is a material for a reflective mask used in EUV lithography using EUV light as exposure light, the reflective mask blank comprises:
a substrate;
a multilayer reflective film that reflects the exposure light and is formed above one main surface of the substrate;
a protective film that protects the multilayer reflective film and is formed above the multilayer reflective film;
an absorption film that absorbs the exposure light and is formed above the protective film; and
an intermediate film provided between the protective film and the absorption film,
wherein the intermediate film includes a first intermediate film containing niobium (Nb) and a second intermediate film that is provided closer to the absorption film than the first intermediate film and is made of a material that can be dry-etched with an oxygen-containing gas, and
the absorption film is made of a material that can be dry-etched with a fluorine-containing gas.

In the reflective mask blank according to the present invention,
the first intermediate film may be a film made of niobium (Nb) alone, a niobium (Nb) compound containing niobium (Nb) and oxygen (O), or combination thereof.

In the reflective mask blank according to the present invention,
the second intermediate film may contain at least one selected from ruthenium (Ru), chromium (Cr), vanadium (V), and molybdenum (Mo).

In the reflective mask blank according to the present invention,
wherein the absorption film may contain at least one selected from tantalum (Ta), rhodium (Rh), platinum (Pt), iridium (Ir), and gold (Au).

In the reflective mask blank according to the present invention,
the second intermediate film may contain ruthenium (Ru), and
the absorption film may contain platinum (Pt).

In the reflective mask blank according to the present invention,
the second intermediate film may contain chromium (Cr), and
the absorption film may contain platinum (Pt).

In the reflective mask blank according to the present invention,
wherein an etching mask film containing chromium (Cr) may be provided on the absorption film.

A method for manufacturing a reflective mask according to the present invention is a method to manufacture the reflective mask from the reflective mask blank according to any one of concepts 1 to 7 comprise:
patterning the absorption film by dry etching using a fluorine-containing gas;
patterning the second intermediate film by dry etching using an oxygen-containing gas; and
patterning the first intermediate film by a sulfuric acid/hydrogen peroxide mixture (SPM).

### EFFECT OF INVENTION

According to the present invention, between the absorption film that can be dry-etched using a fluorine-containing gas and the protective film, the first intermediate film containing niobium (Nb) is provided on the protective film side and the second intermediate film that can be dry-etched using an oxygen (O)-containing gas is provided on the absorption film side, so that it is possible to provide a reflective mask blank in which the protective film is less likely to be damaged during production of a reflective mask, and it is possible to suppress a decrease in thickness and oxidation of the protective film.

### BRIEF DESCRIPTION OF DRAWINGS

FIG. 1 is a cross-sectional view illustrating an example (first aspect) of a reflective mask blank according to an embodiment of the present invention;
FIG. 2 is a cross-sectional view illustrating another example (second aspect) of the reflective mask blank according to the embodiment of the present invention;
FIG. 3 is a cross-sectional view illustrating an example of a reflective mask according to the embodiment of the present invention; and
FIG. 4 is a cross-sectional view illustrating still another example (third aspect) of the reflective mask blank according to the embodiment of the present invention.

### DETAILED DESCRIPTION

Hereinafter, embodiments of the present invention will be described in greater detail.

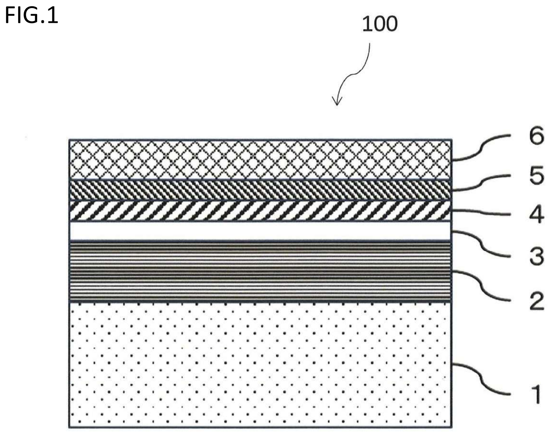

As illustrated in FIG. 1, a reflective mask blank 100 of an embodiment has a substrate 1, a multilayer reflective film 2 that reflects exposure light and is formed on one main surface (surface) of the substrate 1, a protective film 3 that is formed on the multilayer reflective film 2, and an absorption film 6 that absorbs exposure light and is formed above the protective film 3. In addition, the reflective mask blank 100 of the embodiment has a first intermediate film 4 and a second intermediate film 5 between the protective film 3 and the absorption film 6.

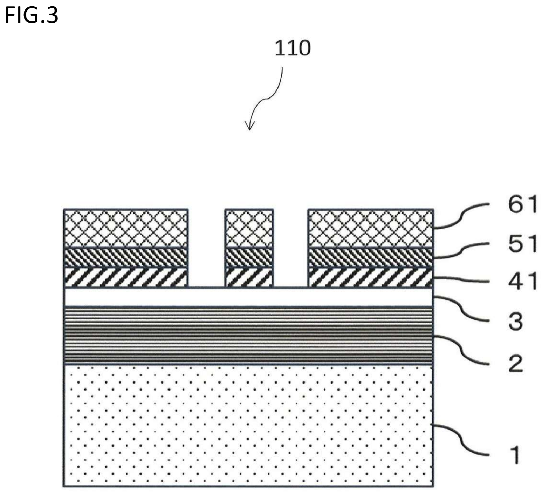

The reflective mask blank 100 is suitable as a material for a reflective mask 110 (see FIG. 3) used in EUV lithography using EUV light as exposure light. The EUV light used in EUV lithography using EUV light as exposure light has a wavelength of 13 to 14 nm, and is usually light having a wavelength of about 13.5 nm. The reflective mask blank 100 and the reflective mask 110 using EUV light as exposure light are also referred to as an EUV mask blank and an EUV mask, respectively.

FIG. 1 is a cross-sectional view illustrating an example (first aspect) of the reflective mask blank 100 of the embodiment. The reflective mask blank 100 has a substrate 1, a multilayer reflective film 2 formed on the substrate 1 in contact with the substrate 1, a protective film 3 formed in contact with the multilayer reflective film 2, and an absorption film 6 formed above the protective film 3. In addition, a first intermediate film 4 and a second intermediate film 5 are provided between the protective film 3 and the absorption film 6.

The substrate 1 preferably has low thermal expansion characteristics for EUV light exposure, and is preferably made of, for example, a material having a thermal expansion coefficient within a range of ±2×10⁻⁸/°C, preferably within a range of ±5×10⁻⁹/°C. Examples of the material include titania-doped quartz glass (SiO₂-TiO₂-based glass). In addition, a substrate having a sufficiently flattened surface is preferably used as the substrate 1, and the surface roughness of the main surface of the substrate 1 is preferably 0.5 nm or less, and more preferably 0.2 nm or less in RMS value. Such surface roughness can be obtained by polishing the substrate 1, for example. Regarding the size of the substrate 1, the substrate 1 preferably has a main surface size of 152 mm square and a thickness of 6.35 mm. The substrate 1 having the above size is a substrate (substrate having a main surface size of 6 inch square and a thickness of 0.25 inches) called a so-called 6025 substrate.

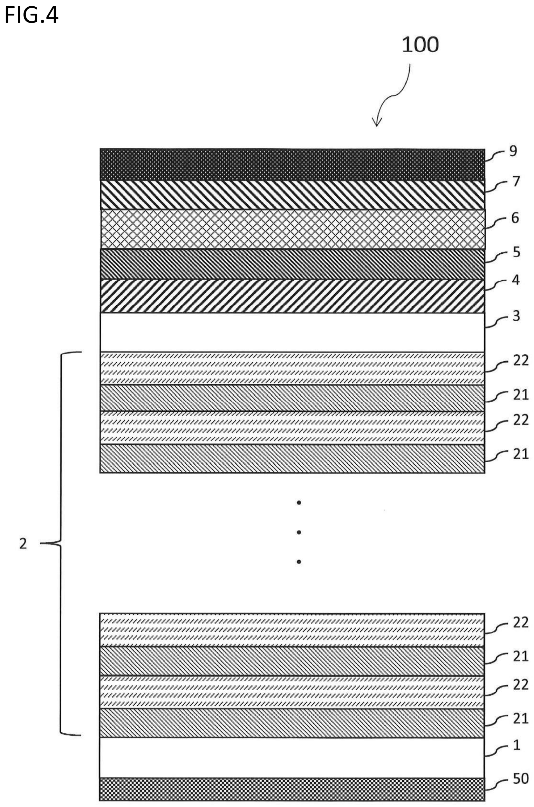

The multilayer reflective film 2 is a film that reflects exposure light in the reflective mask 110 (see FIG. 3). The multilayer reflective film 2 is preferably provided in contact with one main surface of the substrate 1, but another film such as a base film may be provided between the multilayer reflective film 2 and one main surface of the substrate 1. As illustrated in FIG. 4, the multilayer reflective film 2 has a periodically laminated structure in which a high refractive index layer 21 having a relatively high refractive index to exposure light and a low refractive index layer 22 having a relatively low refractive index to exposure light are alternately laminated.

The high refractive index layer 21 is preferably made of a material containing silicon (Si). The high refractive index layer 21 may contain one or more additive elements selected from oxygen (O), nitrogen (N), carbon (C), boron (B), and hydrogen (H), and may be composed of multiple layers including a layer containing an additive element and a layer containing no additive element. The thickness of the high refractive index layer 21 is preferably 3.5 nm or more, and more preferably 4 nm or more, and is preferably 4.9 nm or less, and more preferably 4.4 nm or less.

The low refractive index layer 22 is preferably made of a material containing molybdenum (Mo). The low refractive index layer 22 can also be made of a material containing ruthenium (Ru). A multilayer structure of Mo and Ru may be adopted. The low refractive index layer 22 may contain one or more additive elements selected from oxygen (O), nitrogen (N), carbon (C), boron (B), and hydrogen (H), and may be composed of multiple layers including a layer containing an additive element and a layer containing no additive element. The thickness of the low refractive index layer 22 is preferably 2.1 nm or more, and more preferably 2.6 nm or more, and is preferably 3.5 nm or less, and more preferably 3 nm or less.

The periodically laminated structure may include the high refractive index layer 21 and the low refractive index layer 22, and one or more high refractive index layers 21 and one or more low refractive index layers 22 may be included in one period. The number of layers included in the periodically laminated structure is two or more, and the periodically laminated structure can be composed of, for example, one high refractive index layer 21 and one low refractive index layer 22. In addition, two or more high refractive index layers 21 having different compositions (for example, having different composition ratios, or having different compositions depending on the presence or absence of the additive element) may be included, and two or more low refractive index layers 22 having different compositions (for example, having different composition ratios, or having different compositions depending on the presence or absence of the additive element) may be included. In this case, the number of layers included in the periodically laminated structure is three or more, may be four or more or five or more, and is preferably eight or less. The number of periods is preferably 20 or more, and is preferably 50 or less, and more preferably 40 or less.

The thickness of the multilayer reflective film 2 having the periodically laminated structure is adjusted according to the exposure wavelength and the incidence angle of the exposure light, and is preferably 130 nm or more and 400 nm or less, and more preferably 290 nm or less.

Examples of the method for forming the multilayer reflective film 2 include a sputtering method in which power is supplied to a target and an atmospheric gas is turned into plasma (ionization) by the supplied power to perform sputtering, and an ion beam sputtering method in which a target is irradiated with ion beams. The sputtering method includes a DC sputtering method in which a DC voltage is applied to a target and an RF sputtering method in which a high-frequency voltage is applied to a target. The sputtering method is a film forming method in which, in a state in which a sputtering gas is introduced into a chamber, a voltage is applied to a target, the gas is ionized, and a sputtering phenomenon caused by gas ions is used. In particular, a magnetron sputtering method is advantageous in terms of productivity. The power applied to the target may be either DC or RF, and in a case of DC, pulse sputtering is also included, in which the negative bias applied to the target is reversed for a short period of time to prevent charge-up of the target.

The multilayer reflective film 2 can be formed by, for example, a sputtering method using a sputtering device capable of mounting a plurality of targets. Specifically, a target can be appropriately selected and used from among a molybdenum (Mo) target for forming a layer containing molybdenum (Mo), a ruthenium (Ru) target for forming a layer containing ruthenium (Ru), a silicon (Si) target for forming a layer containing silicon (Si), and the like, and a rare gas such as a helium (He) gas, an argon (Ar) gas, a krypton (Kr) gas, or a xenon (Xe) gas can be used as a sputtering gas to form the multilayer reflective film 2.

In addition, in a case where reactive sputtering using a reactive gas is performed for sputtering, for example, a nitrogen-containing gas such as a nitrogen (N₂) gas when a film containing nitrogen (N) is formed, an oxygen-containing gas such as an oxygen (O₂) gas when a film containing oxygen (O) is formed, a nitrogen oxide gas such as a nitrous oxide (N₂O) gas, a nitrogen monoxide (NO) gas, or a nitrogen dioxide (NO₂) gas when a film containing nitrogen (N) and oxygen (O) is formed, a carbon oxide gas such as a carbon monoxide (CO) gas or a carbon dioxide (CO₂) gas when a film containing carbon (C) and oxygen (O) is formed, a hydrogen-containing gas such as a hydrogen (H₂) gas when a film containing hydrogen (H) is formed, or a hydrocarbon gas such as a methane (CH₄) gas when a film containing carbon (C) and hydrogen (H) is formed, may be used together with a rare gas.

Furthermore, when a layer containing boron (B) is formed, a molybdenum (Mo) target in which boron (B) is added (molybdenum boride (MoB) target), a silicon (Si) target in which boron (B) is added (silicon boride (SiB) target), or the like can be used.

The protective film 3 is also called a capping film. The protective film 3 is a film for protecting the multilayer reflective film 2. The protective film 3 is usually provided in contact with the multilayer reflective film 2. The protective film 3 is made of a material containing ruthenium (Ru) or rhodium (Rh).

Examples of the material containing ruthenium (Ru) include ruthenium (Ru) alone and alloys containing ruthenium (Ru) and a metal or metalloid different from ruthenium (Ru). Examples of the metal or metalloid different from ruthenium (Ru) include rhodium (Rh), niobium (Nb), rhenium (Re), zirconium (Zr), titanium (Ti), chromium (Cr), and silicon (Si). The material containing ruthenium (Ru) is particularly preferably ruthenium (Ru) alone, and the protective film 3 is preferably made of ruthenium (Ru). The content of the metal or metalloid different from ruthenium (Ru) in the protective film 3 is preferably 50 atom% or less, and more preferably 30 atom% or less on average over the entire film. The lower limit of the content of the metal or metalloid different from ruthenium (Ru) in the protective film 3 is not particularly limited, but is preferably 5 atom% or more, and more preferably 10 atom% or more.

Examples of the material containing rhodium (Rh) include rhodium (Rh) alone and alloys containing rhodium (Rh) and a metal or metalloid different from rhodium (Rh). Examples of the metal or metalloid different from rhodium (Rh) include ruthenium (Ru), niobium (Nb), rhenium (Re), zirconium (Zr), titanium (Ti), chromium (Cr), and silicon (Si). The material containing rhodium (Rh) is particularly preferably rhodium (Rh) alone, and the protective film 3 is preferably made of rhodium (Rh). The content of the metal or metalloid different from rhodium (Rh) in the protective film 3 is preferably 50 atom% or less, and more preferably 30 atom% or less on average over the entire film. The lower limit of the content of the metal or metalloid different from rhodium (Rh) in the protective film 3 is not particularly limited, but is preferably 5 atom% or more, and more preferably 10 atom% or more.

The protective film 3 may have a single layer structure or a multilayer structure in which a plurality of layers having different compositions are combined, and the single layer and the respective layers constituting the plurality of layers may have a gradient composition structure in which the composition continuously changes in the thickness direction.

The thickness of the protective film 3 is preferably 1 nm or more, and more preferably 2 nm or more, and is preferably 5 nm or less, and more preferably 4 nm or less.

The protective film 3 can be formed by sputtering using a target appropriately selected from a ruthenium (Ru) target, a rhodium (Rh) target, a target of a metal or metalloid different from the above targets, specifically, a niobium (Nb) target, a rhenium (Re) target, a zirconium (Zr) target, a titanium (Ti) target, a chromium (Cr) target, and a silicon (Si) target, and a target in which two or more selected from ruthenium (Ru), niobium (Nb), rhenium (Re), zirconium (Zr), titanium (Ti), chromium (Cr), and silicon (Si) are mixed, and using a rare gas such as a helium (He) gas, an argon (Ar) gas, a krypton (Kr) gas, or a xenon (Xe) gas as a sputtering gas. For the sputtering, a magnetron sputtering method is preferably used.

The absorption film 6 is a film that absorbs exposure light and reduces a reflectivity in the reflective mask 110. In the reflective mask 110, a transfer pattern is formed by a difference in reflectivity between a part where the absorption film 6 is formed and a part where the absorption film 6 is not formed. The absorption film 6 may be a single layer or include multiple layers, and an antireflection layer or the like may be formed on a surface.

The absorption film 6 is a film of a material that absorbs EUV light and can be patterned by dry etching using a fluorine-containing gas in the embodiment, and preferably contains any one of tantalum (Ta), rhodium (Rh), platinum (Pt), iridium (Ir), and gold (Au), or a mixture of two or more thereof as a main component. Examples thereof include tantalum (Ta), rhodium (Rh), platinum (Pt), iridium (Ir), and gold (Au) as simple substances, and alloys and mixtures such as platinum ruthenium (PtRu), platinum iridium (PtIr), and ruthenium iridium (RuIr). In the embodiment, the "main component" means a metal element or metalloid element contained at the highest atomic percentage.

Any one of tantalum (Ta), rhodium (Rh), platinum (Pt), iridium (Ir), and gold (Au), or the material obtained by mixing two or more thereof may contain oxygen (O), nitrogen (N), carbon (C), boron (B), and the like.

The absorption film 6 (layers constituting the absorption film 6) can be formed by sputtering, and for the sputtering, a magnetron sputtering method is preferably used. Specifically, in the formation using a material containing platinum (Pt), from a platinum (Pt) target or a platinum (Pt)-mixed target (target containing platinum (Pt), and oxygen (O), nitrogen (N), carbon (C), boron (B), and the like), in the formation using a material containing iridium (Ir), from an iridium (Ir) target or an iridium (Ir) mixture target (target containing iridium (Ir), and oxygen (O), nitrogen (N), carbon (C), boron (B), and the like), and in the formation using a material containing gold (Au), from a gold (Au) target or a gold (Au) mixture target (target containing gold (Au), and oxygen (O), nitrogen (N), carbon (C), boron (B), and the like), a target is appropriately selected and used according to the composition, and sputtering using a rare gas such as a helium (He) gas, a neon (Ne) gas, an argon (Ar) gas, a krypton (Kr) gas, or a xenon (Xe) gas as a sputtering gas, or reactive sputtering using, together with a rare gas, a reactive gas such as an oxygen-containing gas, a nitrogen-containing gas, or a carbon-containing gas, specifically, an oxygen (O₂) gas, a nitrogen (N₂) gas, a nitrogen oxide (N₂O, NO, NO₂) gas, or a carbon oxide (CO, CO₂) gas can be performed to form the absorption film 6. In a case where a material containing tantalum (Ta) or rhodium (Rh) is used, the same method can also be used to form the absorption film 6.

The thickness of the absorption film 6 is not particularly limited since the optimum thickness varies depending on the light source and the pattern pitch during exposure. However, the thickness is preferably 20 nm or more, and more preferably 30 nm or more, and is preferably 60 nm or less, and more preferably 50 nm or less.

In the embodiment, specific examples of the dry etching using a fluorine (F)-containing gas include dry etching using a gas including a carbon tetrafluoride (CF₄) gas, a sulfur hexafluoride (SF₆) gas, a hexafluoroethane (C₂F₆) gas, or the like. The fluorine (F)-containing gas may be mixed with a rare gas such as a helium (He) gas, an argon (Ar) gas, a krypton (Kr) gas, or a xenon (Xe) gas.

In a case where the absorption film 6 that can be dry-etched with a fluorine-containing gas is directly laminated above the protective film 3, the protective film 3 is also exposed to dry etching with a fluorine-containing gas when the absorption film 6 is etched. Since ruthenium (Ru) or rhodium (Rh) usually used as the protective film 3 is etched by dry etching with a fluorine-containing gas, the protective film 3 is damaged during over-etching for when the absorption film 6 is etched. In order to prevent this problem, between the protective film 3 and the absorption film 6, the first intermediate film 4 containing Nb is provided on the protective film 3 side (lower side), and the second intermediate film 5 made of a material that is etched with an oxygen-containing gas is provided on the absorption film 6 side (upper side), so that etching can be performed without damaging the protective film 3 during etching of the absorption film 6 that is etched with a fluorine-containing gas.

The first intermediate film 4 is a film containing niobium (Nb). The film containing niobium (Nb) has resistance to dry etching using an oxygen (O)-containing gas, and functions as a film that protects the protective film 3.

The first intermediate film 4 is preferably made of niobium (Nb) alone or a niobium (Nb) compound containing niobium (Nb) and oxygen (O), and may be made of, for example, a niobium oxide (NbO). The niobium (Nb) compound containing oxygen (O) preferably contains niobium (Nb) and oxygen (O) as main components, and a total content of niobium (Nb) and oxygen (O) is preferably 70 atom% or more, more preferably 80 atom% or more, still more preferably 91 atom% or more, and particularly preferably 100 atom% on average over the entire film. In addition, the content of niobium (Nb) is preferably 20 atom% or more, more preferably 28 atom% or more, and still more preferably 29 atom% or more on average in the entire film.

The first intermediate film 4 may be a single layer or include a plurality of layers. Examples of the plurality of layers include combinations of niobium (Nb)-containing layers having different compositions or composition ratios, such as a combination of a layer made of a niobium (Nb) compound containing oxygen (O) and a layer made of niobium (Nb), and a combination of niobium (Nb) compound layers containing oxygen (O) having different composition ratios. In addition, each layer may be a simple composition layer or a gradient composition layer having a gradient composition. In a case where the first intermediate film 4 contains oxygen (O), it is preferable that the oxygen (O) concentration on the front surface side (side separated from the substrate 1) is increased, or a layer made of a niobium (Nb) compound containing oxygen (O) is provided on the front surface side and a layer made of niobium (Nb) or a layer containing niobium (Nb) and containing no oxygen (O) is provided on the substrate 1 side (rear surface side).

The thickness of the first intermediate film 4 may be any film thickness that can protect the protective film 3 during dry etching of the second intermediate film 5 with an oxygen-containing gas. The thickness is preferably 0.5 nm or more, and more preferably 1 nm or more, and is preferably 10 nm or less, and more preferably 5 nm or less.

The first intermediate film 4 can be formed by sputtering. The first intermediate film 4 can be formed by sputtering using, as a target, a niobium (Nb) target, and if necessary, a metal or metalloid target different from niobium (Nb), specifically, a silicon (Si) target or the like, and using, as a sputtering gas, a rare gas such as a helium (He) gas, an argon (Ar) gas, a krypton (Kr) gas, or a xenon (Xe) gas, or reactive sputtering using a reactive gas such as an oxygen-containing gas, a nitrogen-containing gas, or a carbon-containing gas, specifically, an oxygen (O₂) gas, a nitrogen (N₂) gas, a nitrogen oxide (N₂O, NO, NO₂) gas, or a carbon oxide (CO, CO₂) gas together with the rare gas. For the sputtering, a magnetron sputtering method is preferably used.

In a case where the first intermediate film 4 contains oxygen (O), niobium (Nb) is easily oxidized naturally, and thus a film of niobium (Nb) alone is formed and oxidized by being exposed to an atmosphere containing oxygen (O) such as the air, whereby a niobium (Nb) compound containing oxygen (O) can be obtained. In a case where the film of niobium (Nb) alone is oxidized, the film may be heat-treated.

The second intermediate film 5 is made of a material that can be dry-etched with an oxygen-containing gas.

Examples of the material that can be dry-etched with an oxygen-containing gas include materials containing ruthenium (Ru), chromium (Cr), vanadium (V), molybdenum (Mo), and the like. Other elements may be added thereto, and as a result, any material that can be dry-etched with an oxygen-containing gas may be obtained. Examples thereof include Ru, RuO, RuN, RuON, Cr, CrO, CrN, CrON, V, Mo, and MoO.

The film thickness of the second intermediate film 5 is set to such a film thickness that the second intermediate film 5 is not completely etched during etching of the absorption film 6 that can be etched with a gas including a fluorine gas.

When the second intermediate film 5 is etched with an oxygen-containing gas after etching of the absorption film 6, the first intermediate film 4 appears on the surface layer of the patterned part.

The first intermediate film 4 containing Nb or NbO as a main component is easily dissolved in a sulfuric acid/hydrogen peroxide mixture (SPM). Therefore, when it is desired to remove the first intermediate film 4 in the patterned part and expose the protective film 3 on the surface, this can be realized by performing SPM cleaning, and in that case, a mask can be produced without damaging the protective film 3.

As illustrated in FIG. 4, a conductive film 50 used for electrostatically chucking the reflective mask 110 to an exposure device (for example, EUV scanner) may be provided on the other main surface (rear surface), which is a surface opposite to one main surface of the substrate 1, preferably in contact with the other main surface.

The conductive film 50 preferably has a sheet resistance of 100 Ω/□ or less, and its material is not particularly limited. Examples of the material of the conductive film 50 include a material containing tantalum (Ta) or chromium (Cr). In addition, the material containing tantalum (Ta) may contain oxygen (O), nitrogen (N), carbon (C), boron (B), and the like, and the material containing chromium (Cr) may contain oxygen (O), nitrogen (N), carbon (C), and the like. Examples of the material containing tantalum (Ta) include Ta alone and tantalum (Ta) compounds such as TaO, TaN, TaON, TaC, TaCN, TaCO, TaCON, TaB, TaOB, TaNB, TaONB, TaCB, TaCNB, TaCOB, and TaCONB. Specific examples of the material containing chromium (Cr) include Cr alone and chromium (Cr) compounds such as CrO, CrN, CrON, CrC, CrCN, CrCO, and CrCON.

The thickness of the conductive film 50 is not particularly limited as long as the conductive film 50 functions for electrostatic chucking, but is usually about 20 to 300 nm. The thickness of the conductive film 50 is preferably set so that the film stress is balanced with the films and the film patterns formed on one main surface (surface) side after formation of the reflective mask 110, that is, after formation of the pattern of the absorption film 6. The conductive film 50 may be formed before the multilayer reflective film 2 is formed, or may be formed after all the films of the substrate 1 on the multilayer reflective film 2 side are formed. In addition, the conductive film 50 may be formed after some of the films of the substrate 1 on the multilayer reflective film 2 side are formed, and then the remaining films of the substrate 1 on the multilayer reflective film 2 side may be formed. The conductive film 50 can be formed by, for example, a magnetron sputtering method.

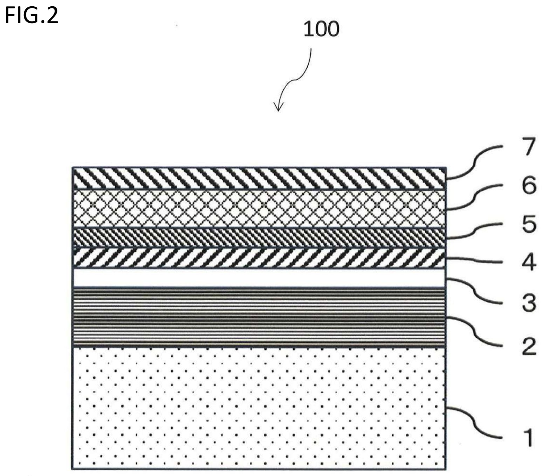

As illustrated in FIG. 2, an etching mask film 7 having different etching characteristics from the absorption film 6 can be provided as a hard mask film for when the absorption film 6 is etched on the side of the absorption film 6 away from the substrate 1. The etching mask film 7 is preferably provided in contact with the absorption film 6. The etching mask film 7 may be a single layer or include multiple layers.

FIG. 2 is a cross-sectional view illustrating an example (second aspect) of the reflective mask blank 100 of the embodiment. The reflective mask blank 100 has a substrate 1, a multilayer reflective film 2 formed on the substrate 1 in contact with the substrate 1, a protective film 3 formed in contact with the multilayer reflective film 2, a first intermediate film 4 formed in contact with the protective film 3, a second intermediate film 5, an absorption film 6 formed in contact with the second intermediate film 5, and an etching mask film 7 formed in contact with the absorption film 6.

In a case where the absorption film 6 is made of a material that can be dry-etched using a fluorine-containing gas, the etching mask film 7 preferably contains chromium (Cr), and is preferably made of a material containing chromium (Cr). Since the material containing chromium (Cr) is hardly etched by dry etching using a fluorine-containing gas, an etching mask film 7 that is made of a material containing chromium (Cr) and functions as an etching mask for when the absorption film 6 is dry-etched is suitable. Examples of the material containing chromium (Cr) include Cr alone, CrO, CrN, CrON, CrC, CrOC, CrNC, and CrONC.

After the pattern of the absorption film 6 is formed, the etching mask film 7 may be left on the reflective mask 110 as a reflectivity reducing layer for reducing the reflectivity at a wavelength of the light used in inspection such as pattern inspection, or may be removed so as not to remain on the reflective mask 110.

The thickness of the etching mask film 7 is not particularly limited. However, in a case where the thickness is too small, there is a concern that the etching mask film 7 may not function as a hard mask. In a case where the thickness is too large, there is a concern that processing characteristics are deteriorated. Therefore, the thickness is preferably 1 nm or more, more preferably 2 nm or more, and still more preferably 5 nm or more, and is preferably 20 nm or less, and more preferably 10 nm or less.

The etching mask film 7 can be formed by sputtering. Specifically, in the formation using a material containing chromium (Cr), from a chromium (Cr) target or a chromium (Cr) compound target (target containing chromium (Cr), and oxygen (O), nitrogen (N), carbon (C), and the like), a target is appropriately selected and used according to the composition, and sputtering using a rare gas such as a helium (He) gas, an argon (Ar) gas, a krypton (Kr) gas, or a xenon (Xe) gas as a sputtering gas, or reactive sputtering using, together with a rare gas, a reactive gas such as an oxygen-containing gas, a nitrogen-containing gas, or a carbon-containing gas, specifically, an oxygen (O₂) gas, a nitrogen (N₂) gas, a nitrogen oxide (N₂O, NO, NO₂) gas, a carbon oxide (CO, CO₂) gas, a hydrogen (H₂) gas, or a hydrocarbon gas (for example, methane (CH₄) gas) can be performed to form the etching mask film 7. For the sputtering, a magnetron sputtering method is preferably used.

As illustrated in FIG. 4, the reflective mask blank 100 of the embodiment may have a resist film 9 formed on the side farthest from the substrate 1. The resist film 9 is preferably an electron beam (EB) resist.

From the reflective mask blank 100, for example, a reflective mask 110 having a substrate 1, a multilayer reflective film 2 formed on one main surface of the substrate 1, a protective film 3 formed in contact with the multilayer reflective film 2, a pattern 41 of a first intermediate film 4 formed in contact with the protective film 3, a pattern 51 of a second intermediate film 5 formed in contact with the pattern 41 of the first intermediate film 4, and a pattern (absorption film pattern) 61 of an absorption film 6 formed in contact with the pattern 51 of the second intermediate film 5 can be manufactured (see FIG. 3). In the reflective mask 110, a transfer pattern is formed by a difference in reflectivity between a part where the absorption film 6 is formed and a part where the absorption film 6 is not formed.

FIG. 3 is a cross-sectional view illustrating an example of the reflective mask 110 of the embodiment. The reflective mask 110 includes a substrate 1, a multilayer reflective film 2 formed on the substrate 1 in contact with the substrate 1, a protective film 3 formed in contact with the multilayer reflective film 2, a pattern 41 of a first intermediate film 4 formed in contact with the protective film 3, a pattern 51 of a second intermediate film 5 formed in contact with the pattern 41 of the first intermediate film 4, and a pattern 61 of an absorption film 6 formed in contact with the pattern 51 of the second intermediate film 5. In the reflective mask 110, the pattern 61 of the absorption film 6 is formed above the protective film 3 via the pattern 41 of the first intermediate film 4 and the pattern 51 of the second intermediate film 5.

The reflective mask 110 of the embodiment can be manufactured by a method including a step of preparing the reflective mask blank 100, a step of forming a resist film 9 on the absorption film 6 if necessary, a step of forming a resist pattern from the resist film 9 on the absorption film 6, a step of forming a pattern of the absorption film 6 by etching the absorption film 6 with the resist pattern as an etching mask, a step of removing the resist pattern, and a step of removing the first intermediate film 4 and the second intermediate film 5 in a part exposed by removing the absorption film 6.

The absorption film 6 and the second intermediate film 5 made of a material containing chromium (Cr) can be etched by dry etching using a gas containing chlorine (Cl) and oxygen (O).

In this case, since the first intermediate film 4 containing niobium (Nb) is not etched by dry etching using a gas containing chlorine (Cl) and oxygen (O), damage to the protective film 3 can be further prevented.

The absorption film 6 made of a material containing tantalum (Ta) can be etched by dry etching using a chlorine (Cl)-containing gas or a fluorine (F)-containing gas.

In the dry etching of the absorption film 6 containing tantalum (Ta), dry etching using a fluorine (F)-containing gas is preferable when a part containing oxygen (O) formed by natural oxidation or the like is etched, and dry etching using a chlorine (Cl)-containing gas is preferable when a part containing no oxygen (O) is etched. Therefore, the absorption film 6 containing tantalum (Ta) is preferably patterned by initially performing dry etching using a fluorine (F)-containing gas and then switching midway to dry etching using a chlorine (Cl)-containing gas. In this case, since the first intermediate film 4 has low resistance to dry etching using a chlorine (Cl)-containing gas, the etching is preferably performed so that the first intermediate film 4 remains. In order to perform the etching so that the first intermediate film 4 remains, for example, an end point detector or the like attached to an etching device can be used.

In addition, the reflective mask 110 of the embodiment can be manufactured by a method including a step of preparing the reflective mask blank 100, a step of forming a resist film 9 on the etching mask film 7 if necessary, a step of forming a resist pattern from the resist film 9 on the etching mask film 7, a step of forming a pattern of the etching mask film 7 by etching the etching mask film 7 with the resist pattern as an etching mask, a step of forming a pattern of the absorption film 6 by etching the absorption film 6 with the pattern of the etching mask film 7 as an etching mask, a step of removing the resist pattern, a step of removing the pattern of the etching mask film 7, and a step of removing the first intermediate film 4 and the second intermediate film 5 in a part exposed by removing the absorption film 6.

After the pattern of the absorption film 6 is formed, in a case where the etching mask film 7 is made of a material containing tantalum (Ta), the pattern of the etching mask film 7 can be removed by dry etching using a chlorine (Cl)-containing gas or a fluorine (F)-containing gas, and in a case where the etching mask film 7 is made of a material containing chromium (Cr), the pattern of the etching mask film 7 can be removed by dry etching using a gas containing chlorine (Cl) and oxygen (O).

In a case where the absorption film 6 contains tantalum (Ta), a film containing chromium (Cr) is provided as the etching mask film 7, the etching mask film 7 is patterned by dry etching using a gas containing chlorine (Cl) and oxygen (O) to form a pattern of the etching mask film 7, the absorption film 6 is patterned with the pattern of the etching mask film 7 as an etching mask, and then the etching mask film 7 can be removed by dry etching using a gas containing chlorine (Cl) and oxygen (O).

In this case, since the first intermediate film 4 containing niobium (Nb) is not etched by dry etching using a gas containing chlorine (Cl) and oxygen (O), damage to the protective film 3 can be prevented.

The resist pattern and the first intermediate film 4 in a part exposed by removing the absorption film 6 and the second intermediate film 5 can be removed by a sulfuric acid/hydrogen peroxide mixture (SPM).

In addition, a niobium oxide (NbO) is formed on the surface of the first intermediate film 4 in a part exposed by removing the absorption film 6 and the second intermediate film 5. The niobium oxide (NbO) is etched with a chlorine (Cl)-containing gas or a fluorine (F)-containing gas. Therefore, in a case where the first intermediate film is etched by such etching, the etching selectivity to the protective film cannot be obtained, and the protective film is damaged. Therefore, the first intermediate film 4 is preferably removed by a sulfuric acid/hydrogen peroxide mixture (SPM). In that case, the first intermediate film 4 can be removed simultaneously with the removal of the resist pattern.

The pattern of the absorption film 6 and the exposed protective film 3 can be subjected to a treatment in which the pattern of the absorption film 6 and the exposed protective film 3 are brought into contact with a sulfuric acid/hydrogen peroxide mixture (SPM), such as cleaning using a sulfuric acid/hydrogen peroxide mixture (SPM).

### Examples

Hereinafter, the present invention will be described in detail with reference to Examples and Comparative Examples, but is not limited to the following Examples.

### [Example 1]

On one main surface of a precision-polished substrate 1 having a low thermal expansion coefficient and made of titania-doped SiO₂, a multilayer reflective film 2 in which a molybdenum (Mo) layer and a silicon (Si) layer were alternately laminated by 40 pairs (periods), with one pair (period) consisting of a molybdenum (Mo) layer having a thickness of 3 nm and a silicon (Si) layer having a thickness of 4 nm, was formed by sputtering. In that case, an uppermost layer of the multilayer reflective film 2 was made of 1 nm-thick Mo.

Next, a ruthenium (Ru) film having a thickness of 2 nm was formed as a protective film 3 on the multilayer reflective film 2. The multilayer reflective film 2 and the protective film 3 have a reflectivity of 66% when EUV light having a wavelength of 13.5 nm is made incident at an incidence angle of 6°.

Next, a niobium oxide (NbO) film (Nb:O=2:5 (atomic ratio)) having a thickness of 2 nm was formed as a first intermediate film 4 on the protective film 3. The niobium oxide (NbO) film was formed by first forming a niobium (Nb) film by sputtering while applying a power of 750 W to a niobium (Nb) target and flowing an argon (Ar) gas at a flow rate of 12 sccm, and then oxidizing the niobium (Nb) film through a heat treatment at 150°C for 10 minutes in the air.

Next, a RuON film having a thickness of 10 nm was formed as a second intermediate film 5. The RuON film was formed by sputtering using a Ru target and introducing Ar, O₂, and N₂ gases.

Next, a Pt film having a thickness of 34 nm was formed as an absorption film 6. The film was formed by a sputtering device capable of simultaneously mounting a Pt target and a Ru target and of simultaneous discharge.

Next, a chromium nitride (CrN) film (Cr:N=4:1 (atomic ratio)) having a thickness of 10 nm was formed as an etching mask film 7 on the absorption film 6. The chromium nitride (CrN) film was formed by sputtering while applying a power of 1000 W to a chromium (Cr) target and flowing an argon (Ar) gas at a flow rate of 20 sccm and a nitrogen (N₂) gas at 10 sccm.

In addition, as a conductive film 50, a tantalum nitride (TaN) film having a thickness of 70 nm was formed on the other main surface of the substrate 1 by sputtering to obtain a reflective mask blank 100.

A reflective mask 110 was manufactured from the obtained reflective mask blank 100. First, an electron beam (EB) resist was applied onto the etching mask film 7 to form a resist film 9. A pattern was written on the resist film 9 by electron beams (EB), followed by development, to form a resist pattern having a line-and-space (L/S) pattern with a line width of 200 nm.

Next, with the resist pattern as an etching mask, a pattern of the etching mask film 7 was formed by dry etching using a gas including a chlorine (Cl₂) gas and an oxygen (O₂) gas. The dry etching was performed through an inductively coupled plasma (ICP) method under the conditions of Cl₂ flow rate: 185 sccm, O₂ flow rate: 55 sccm, He flow rate: 9.25 sccm, pressure: 6 mTorr (0.8 Pa), ICP power: 400 W, RIE voltage: 700 V, and over-etching: 454 seconds. Next, with the pattern of the etching mask film 7 as a mask, the absorption film 6 was etched using an SF₆ gas, and then the second intermediate film 5 was etched using a Cl₂ gas and an O₂ gas. In this case, it was possible to simultaneously peel off the etching mask made of CrN.

Next, by a sulfuric acid/hydrogen peroxide mixture (SPM), the resist pattern was removed and the first intermediate film 4 in a part exposed by removing the absorption film 6 was removed also, thereby obtaining the reflective mask 110.

When a cross section of the part where the absorption film 6 was etched was observed by a transmission electron microscope (TEM), the first intermediate film 4 was removed, but the protective film 3 remained without being damaged in the same form as when it was formed. In addition, a good pattern including the first intermediate film 4, the second intermediate film 5, and the absorption film 6 was obtained.

### [Example 2]

A multilayer reflective film 2, a protective film 3, and a first intermediate film 4 were formed in the same manner as in Example 1, and then a chromium nitride (CrN) film was formed in a thickness of 5 nm as a second intermediate film 5. An absorption film 6, an etching mask film 7, and a conductive film 50 on the other main surface of the substrate 1 were formed in the same manner as in Example 1, and a reflective mask blank 100 was obtained.

Next, a resist pattern was formed in the same manner as in Example 1, and then the etching mask film 7, the absorption film 6, the second intermediate film 5, and the first intermediate film 4 were patterned in the same manner as in Example 1 to form patterns of the first intermediate film 4, the second intermediate film 5, and the absorption film 6, thereby obtaining a reflective mask 110.

When a cross section of the part where the absorption film 6 was etched was observed by a transmission electron microscope (TEM), the first intermediate film 4 was removed, but the protective film 3 remained without being damaged in the same form as when it was formed. In addition, a good pattern including the first intermediate film 4, the second intermediate film 5, and the absorption film 6 was obtained.

### [Comparative Example 1]

A reflective mask blank 100 was obtained in the same manner as in Example 1, except that the first intermediate film 4 functioning as an etch-stop film was not formed.

Next, in the same manner as in Example 1, a resist pattern was formed, and then a pattern of the etching mask film 7 was formed.

Next, in the same manner as in Example 1, the absorption film 6 was patterned by dry etching using a gas including an SF₆ gas with the etching mask film 7 as a mask, to form a pattern of the absorption film 6.

When a cross section of the part where the absorption film 6 was etched was observed by a transmission electron microscope (TEM), the protective film 3 became thin and damaged, and it was not possible to obtain a good reflective mask 110.

### Reference Signs List

- 1: Substrate
- 2: Multilayer reflective film
- 3: Protective film
- 4: First intermediate film
- 5: Second intermediate film
- 6: Absorption film
- 7: Etching mask film
- 41: Pattern of first intermediate film
- 51: Pattern of second intermediate film
- 61: Pattern of absorption film
- 100: Reflective mask blank
- 110: Reflective mask

## Claims

1. A reflective mask blank that is a material for a reflective mask used in EUV lithography using EUV light as exposure light, the reflective mask blank comprising:
a substrate (1);
a multilayer reflective film (2) that reflects the exposure light and is formed above one main surface of the substrate (1);
a protective film (3) that protects the multilayer reflective film (2) and is formed above the multilayer reflective film (2);
an absorption film (6) that absorbs the exposure light and is formed above the protective film (3); and
an intermediate film provided between the protective film (3) and the absorption film (6),
wherein the intermediate film includes a first intermediate film (4) containing niobium (Nb) and a second intermediate film (5) that is provided closer to the absorption film (6) than the first intermediate film (4) and is made of a material that can be dry-etched with an oxygen-containing gas, and
the absorption film (6) is made of a material that can be dry-etched with a fluorine-containing gas.

2. The reflective mask blank according to claim 1,
wherein the first intermediate film (4) is a film made of niobium (Nb) alone, a niobium (Nb) compound containing niobium (Nb) and oxygen (O), or combination thereof.

3. The reflective mask blank according to claim 1 or 2,
wherein the second intermediate film (5) contains at least one selected from ruthenium (Ru), chromium (Cr), vanadium (V), and molybdenum (Mo).

4. The reflective mask blank according to any one of claims 1 to 3,
wherein the absorption film (6) contains at least one selected from tantalum (Ta), rhodium (Rh), platinum (Pt), iridium (Ir), and gold (Au).

5. The reflective mask blank according to any one of claims 1 to 4,
wherein the second intermediate film (5) contains ruthenium (Ru), and
wherein the absorption film (6) contains platinum (Pt).

6. The reflective mask blank according to any one of claims 1 to 4,
wherein the second intermediate film (5) contains chromium (Cr), and
wherein the absorption film (6) contains platinum (Pt).

7. The reflective mask blank according to any one of claims 1 to 6,
wherein an etching mask film containing chromium (Cr) is provided on the absorption film (6).

8. A method for manufacturing a reflective mask from the reflective mask blank according to any one of claims 1 to 7 comprising:
patterning the absorption film (6) by dry etching using a fluorine-containing gas;
patterning the second intermediate film (5) by dry etching using an oxygen-containing gas; and
patterning the first intermediate film (4) by a sulfuric acid/hydrogen peroxide mixture (SPM).
